# EUROPEAN PATENT APPLICATION

(11) **EP 2 352 176 A1**
(43) Date of publication of application: **03.08.2011**
(21) Application number: 09829066.1
(22) Date of filing: 24.11.2009
(51) Int. Cl.: H01L 31/042, H01L 31/052

(54) **SOLAR CELL MANUFACTURING METHOD AND SOLAR CELL**

(30) Priority: 27.11.2008 JP 2008302463
(71) Applicant: Toyota Jidosha Kabushiki Kaisha, Toyota-shi, Aichi 471-8571 (JP)
(72) Inventor: KITAO, Noriyuki, Toyota-shi Aichi 471-8571 (JP); INOUE, Shintaro, Toyota-shi Aichi 471-8571 (JP); SUGA, Yoshinori, Toyota-shi Aichi 471-8571 (JP)
(74) Representative: Winter, Brandl, Fürniss, Hübner, Röss, Kaiser, Polte - Partnerschaft
(86) International application number: PCT/JP2009/069797
(87) International publication number: WO 2010/061818

(57) **Abstract**

A method of manufacturing a solar cell according to the present invention is a method of manufacturing a solar cell which includes a reflective part 5, 6 configured to reflect sunlight to a back surface of a photovoltaic power generating part 3. The reflective part includes a reflective plate 6 and a backing substrate 5. The method includes a laminate forming process in which the reflective plate 6 and the backing substrate 5 are formed concurrently by laminate forming. With this arrangement, a method of manufacturing a solar cell, which can improve efficiency of a manufacturing process as a whole, is obtained.

## Description

### TECHNICAL FIELD

The present invention is related to a method of manufacturing a solar cell and the solar cell which performs electric power generation by making full use of sunlight which can be an alternative to energy from oil.

### BACKGROUND ART

Recently, research on the solar cell and development of the solar cell that generates electric power by making full use of sunlight, have been conducted. The sunlight may be alternative energy for an engine or a thermal power plant utilizing oil or coal which emits carbon dioxide which causes global warming. Such a solar cell is likely to be promising because it can be applied to various applications, such as applications for an artificial satellite, a local generator, and a commercial power supply.

A general configuration of such a solar cell is proposed in which cells for solar generation consisting of multicrystal or single crystal silicon, which are connected in series, are sealed by resin, glass, etc., to form a flat cell string in such a manner that plural cells are spaced uniformly in lateral and vertical directions in the flat cell string; a front plate consisting of transparent resin, glass, etc., is provided on a front side of the cell string; a backing substrate consisting of transparent resin, glass, etc., is provided on a back side of the cells included in the cell string; and a mirror with a bellows shape for collecting sunlight onto the cells is provided on a back side of the backing substrate.

A general method of manufacturing the solar cell adopts the combined use of laminate forming and vapor deposition. In this case, sealants, which are made from EVA (Ethylene Vinyl Acetate Copolymer), for example, are provided between the front plate and the cell string and between the cell string and the backing substrate, respectively.

The manufacturing method is performed as follows: after stacking the front plate, the sealant, the cell string, the sealant and the backing substrate in this order a predetermined pressure from the side of the backing plate is applied with a laminator jig under a predetermined temperature condition to form the bellows shaped surface on the backing substrate and interlay couple the front plate, the cell string and the backing substrate; and an Ag-Al film, a SUS film and an Ag-Al film, for example, are formed and stacked in this order on the bellows shaped surface of the backing plate by using a method disclosed in JP2000-258615 A or vapor deposition method including a vacuum vapor deposition method and a metal vapor deposition method.

However, according to such a manufacturing method, two processes, that is to say, a laminate forming process and a reflective plate vapor depositing process are indispensable. Further, a temperature condition and an atmospheric condition (pressure condition) required for the laminate forming process are greatly different from those required for the reflective plate vapor depositing process. Thus, it is not possible to simultaneously perform the laminate forming process and the reflective plate vapor depositing process, resulting in increased working time as a whole manufacturing process, that is to say, increased tact time. Further, the cost of the reflective plate vapor depositing process is high in general. For this reason, there is a problem that it results in the increased tact time and cost in manufacturing the solar cell and reduces efficiency of a manufacturing process as a whole.

### SUMMARY OF INVENTION

Therefore, an object of the present invention is to provide a solar cell and a method of manufacturing the same which improves efficiency of a manufacturing process as a whole.

In order to achieve the aforementioned objects, according to the present invention a method of manufacturing a solar cell is provided. The solar cell includes a reflective part configured to reflect sunlight to a back surface of a photovoltaic power generating part, said reflective part including a reflective plate and a backing substrate. The method comprises a laminate forming process in which the reflective plate and the backing substrate are formed concurrently by laminate forming.

According to the present invention, a method of manufacturing a solar cell, which improves efficiency of a whole manufacturing process, can be obtained.

### BRIEF DESCRIPTION OF DRAWINGS

Fig. 1 is a diagram for schematically illustrating an embodiment of a method of manufacturing a solar cell according to the present invention; and
Fig. 2 is a diagram for schematically illustrating an embodiment of a method of manufacturing a solar cell according to the present invention.

### EXPLANATION FOR REFERENCE NUMBERS

1 solar cell (module)
2 front plate
3 cell string (photovoltaic power generating part)
   3a cell
4 sealant
5 backing substrate
6 mirror (reflective plate, 5+6: a reflective part)
   6a Ag-Al film
   6b SUS film
   6c Ag-Al film
7 transparent adhesive film
   51 laminator jig

### BEST MODE FOR CARRYING OUT THE INVENITON

In the following, the best mode for carrying out the present invention will be described in detail by referring to the accompanying drawings.

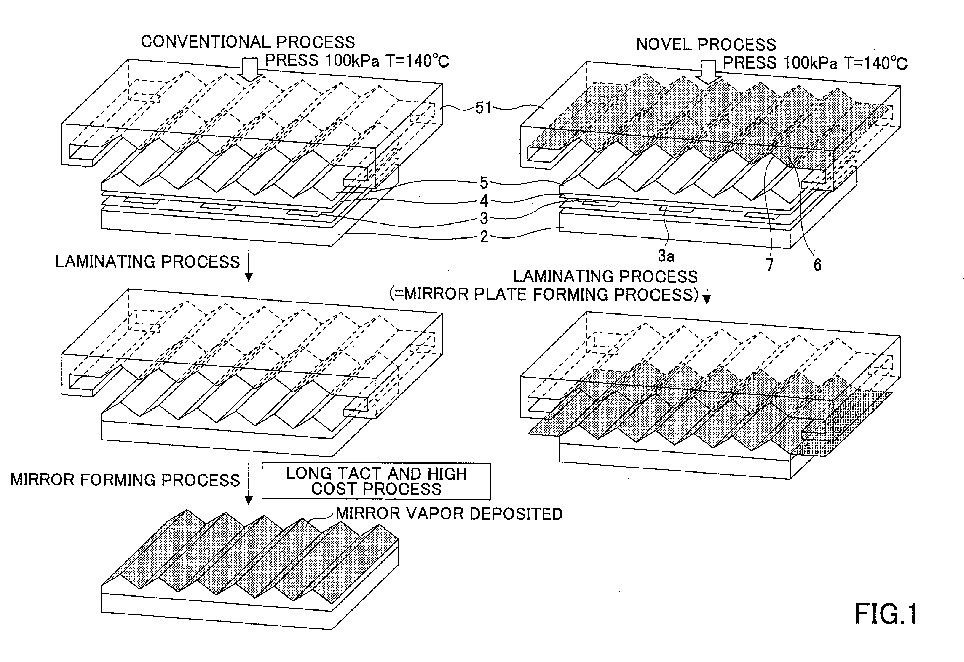

Fig. 1 is a diagram for schematically illustrating an embodiment of a midway state of a manufacturing process of a method of manufacturing a solar cell according to the present invention, as well as a manufacturing process of a method of manufacturing a solar cell according to prior art.

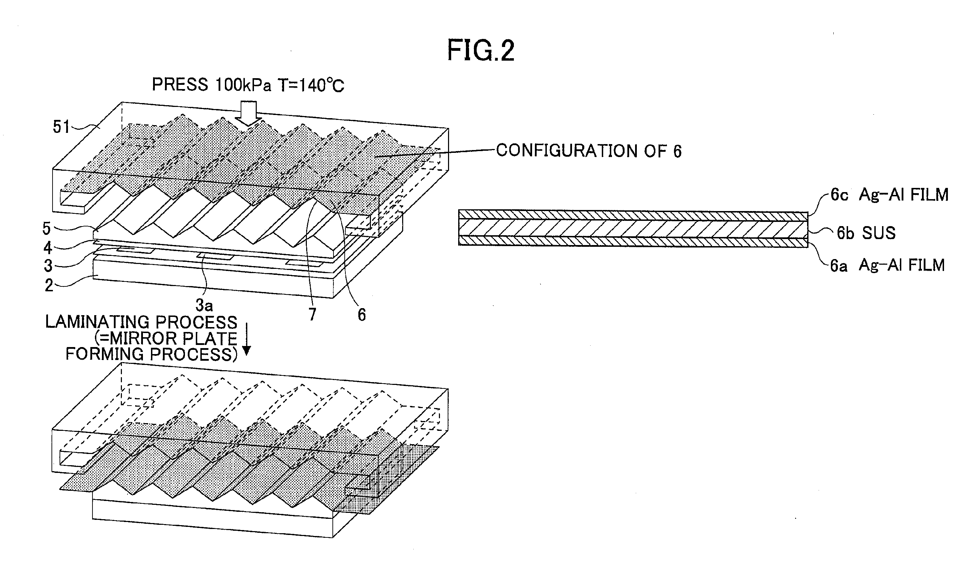

Fig. 2 is a diagram for schematically illustrating an embodiment of a completed state of the manufacturing process of the method of manufacturing a solar cell according to the present invention.

In Fig. 1, the manufacturing process of the method of manufacturing a solar cell according to the present invention, that is to say, a novel process is shown on the right side, and the manufacturing process of the method of manufacturing a solar cell according to prior art, that is to say, a conventional process is shown on the left side.

A solar cell (module) 1, which is presented to the novel process shown on the right side in Fig. 1, is configured by stacking a front plate 2, a cell string 3, a pair of sealants 4, a backing substrate 5, and an Ag-Al film 6a, a SUS film 6b and an Ag-Al film 6c which form a mirror 6 in this order.

The front plate 2 is formed by a glass material, a synthetic resin, etc., which is transparent to the sunlight. The glass material may include various materials, such as a white plate glass, a tempered glass, a semi-tempered glass, a heat ray reflective glass, etc. Further, the synthetic resin may include a polycarbonate resin, etc.

The cell string 3 forms a photovoltaic power generating part. The cell string 3 is configured as follows: cells 3a for solar generation consisting of multicrystal or single crystal silicon are spaced substantially uniformly in a lateral direction in Fig. 1; the cells 3a are connected in series, and a state in which output terminals thereof (not shown) are extended backwardly in Fig. 1; and in this state the cell 3a and the output terminals thereof are sandwiched by resin, glass, etc., in a up-down direction to form a flat piece.

The sealants 4 are sealed between the cell string 3 and the front plate 2, and between the cell string 3 and the backing substrate 5. The sealants 4 are EVA (Ethylene Vinyl Acetate Copolymer), for example. The sealants 4 prevent air gaps from forming between the cell string 3 and the front plate 2, and between the cell string 3 and the backing substrate 5. The sealants 4 generate EVA cross-linking, that is to say, a polymerization cross-linking with the cell string 3, the front plate 2 and the backing substrate 5 under predetermined pressure and temperature in the laminating forming to securely couple to the cell string 3, the front plate 2 and the backing substrate 5. It is noted that in Fig. 1 the sealant 4 between the cell string 3 and the front plate 2 is not shown.

It is noted that a coupling by the completion of the EVA cross-linking does not require an intermediate material such as an adhesive agent; however, a coupling may be implemented by using the adhesive agent.

The backing substrate 5 is transparent to the sunlight. The backing substrate is formed of a synthetic resin, etc., and has a backing side which can be formed and shaped by a bellows-like lower wave surface shape of a laminator jig 51. The laminator jig 51 is used in the laminate forming process in Fig. 1.

The mirror 6 forms a reflective plate. The mirror 6 in this example is formed by stacking the Ag-Al film 6a, the SUS film 6b and the Ag-Al film 6c. The mirror 6 has a bellows-like wave surface shape formed when it is pressed by the bellows-like wave surface shape of the laminator jig 51 in the laminate forming process in Fig. 1. The mirror 6 has a function of reflecting the sunlight incident from the front plate 2 and collecting the sunlight onto the cells 3a of the cell string 3.

The cells 3a of the cell string 3 perform photovoltaic power generation based on the sunlight which is incident from the front plate 2 and collected and reflected by the mirror 6, and generate a predetermined voltage at the output terminals thereof (not shown).

Next, the novel process on the right side of Fig. 1 is described in detail in comparison with the conventional process on the left side of Fig. 1. As shown in an upper side on the right side of Fig. 1, at an initial stage of the novel process, on a support plate (not shown) for the laminating forming are stacked the front plate 2, the sealant 4, the cell string 3, the sealant 4, the backing substrate 5, a transparent adhesive film 7, the Ag-Al film 6a, the SUS film 6b and the Ag-Al film 6c in this order. Then, the temperature and the pressure in a chamber are adjusted in such a manner that the temperature condition meets T = 140 degrees Celsius, and the laminator jig 51 as shown in the upper side on the right side of Fig. 1 is further pressed down from the upper side of the support plate. At that time, the laminator jig 51 is pressed down by appropriate means such as hydraulic means downwardly in Fig. 1 such that the pressure between the laminator jig 51 and the support plate meets P = 100 kPa.

According to the laminate forming process, that is to say, only one process, an interfacial effect between the Ag-Al film 6a and the SUS film 6b and an interfacial effect between the SUS film 6b and the Ag-Al film 6c couple the interfaces therebetween to form the mirror 6 as shown in a cross-sectional view in the right side in Fig. 2. At the same time, the Ag-Al film 6a, that is to say, the mirror 6 is coupled to the backing substrate 5 by adhesiveness of the transparent adhesive film 7. Further, the front plate 2, the sealant 4, the cell string 3, the sealant 4, the backing substrate 5 and the mirror 6 are coupled in this order to be integrated together (i.e., modularized) by the EVA cross-linking (i.e., the polymerization cross-linking) to form the solar cell 1.

To the contrary, according to the conventional process shown in the left side in Fig. 1, on a support plate (not shown) for the laminating forming are stacked the front plate 2, the cell string 3, the sealant 4 and the backing substrate 5 in this order. Then, the temperature and the pressure in a chamber are adjusted in such a manner that the temperature condition meets T = 140 degrees Celsius, and the laminator jig 51 is pressed against, as shown in the upper side on the left side of Fig. 1. At that time, the laminator jig 51 is pressed down by appropriate means such as hydraulic means downwardly in Fig. 1 such that the pressure between the laminator jig 51 and the support plate meets P = 100 kPa. As a result, a bellows-like wave surface shape is formed on the back side of the backing substrate 5.

After the laminating forming process according to the prior art is completed, the laminator jig 51 is raised above in Fig.1, as shown in at the middle in the left side in Fig. 1. After separating the laminator jig 51 from the backing substrate 5, the temperature and the pressure in the chamber are adjusted again in such a manner that the temperature condition in the chamber is suited for the mirror vapor depositing process (i.e., the reflective plate vapor depositing process). Then, the mirror is formed on the bellows-like wave surface of the back side of the backing substrate 5 using a known vapor deposition method.

According to the method of manufacturing the solar cell of the present embodiment described above, the following effects can be obtained. According to the method of manufacturing the solar cell of the present embodiment described in detail in connection with the right side in Fig. 1 and Fig. 2, it is possible to eliminate a vapor deposition process in which the Ag-Al film 6a, the SUS film 6b and the Ag-Al film 6c are formed and stacked on the bellows-like wave surface of the backing substrate 5 in this order by the vapor deposition method after performing the laminate forming process at first.

In other words, according to the method of manufacturing the solar cell of the present embodiment, it is possible to avoid performing the two processes of the laminate forming process and the vapor deposition process in sequence in a time series, which is required in prior art.

In other words, according to the method of manufacturing the solar cell of the present embodiment, two processes of the laminate forming process and the vapor deposition process become not indispensable. According to the prior art, these two processes are necessarily performed in sequence in a time series. It is not possible to simultaneously perform the laminate forming process and the reflective plate vapor depositing process because the temperature condition and the atmospheric condition (pressure condition) required for the laminate forming process are greatly different from those required for the reflective plate vapor depositing process. According to the method of manufacturing the solar cell of the present embodiment, the reflective plate vapor depositing process itself is eliminated, and instead of it, in the laminate forming process the front plate 2, the sealant 4, the cell string 3, the sealant 4 and the backing substrate 5 can be formed integrally and simultaneously to implement couplings therebetween.

In particular, if the laminate forming process and the reflective plate vapor depositing process are performed successively in time series in the same chamber, after adjusting the temperature and the pressure to implement the temperature condition and the atmospheric condition required for the laminate forming process, an operation is required for adjusting the temperature and the pressure in the chamber to different values to implement the temperature condition and the atmospheric condition required for the reflective plate vapor depositing process again. To the contrary, according to the method of manufacturing the solar cell of the present embodiment, adjustment or setting operation need not be performed after merely setting once the temperature and the pressure to meet the temperature condition and the atmospheric condition required for the laminate forming process.

Further, according to the prior art method of manufacturing the solar cell, it is necessary to perform the two processes of the laminate forming process and the vapor deposition process in sequence in a time series. Thus, increased working time for a whole manufacturing process, that is to say, increased tact time is inevitable. To the contrary, according to the method of manufacturing the solar cell of the present embodiment, the re-adjustment operation of the temperature and the pressure and operations required for the reflective plate vapor depositing process can be eliminated. Thus, it is possible to shorten the tact time in a working process as a whole.

Further, according to the method of manufacturing the solar cell of the present embodiment, the reflective plate vapor depositing process whose cost is high in general can be eliminated. Thus, it is possible to prevent cost increase in manufacturing the solar cell and thus implement cost reduction. Accordingly, according to the method of manufacturing the solar cell of the present embodiment, it is possible to improve efficiency in the manufacturing process of the solar cell as a whole.

Further, the mirror 6 formed by the laminate forming process presents greater bonding strength at the joint to the backing substrate 5 in comparison with the mirror which is vapor-deposited after the laminate forming process according to the prior art. At the same time, the respective bonding strengths between the Ag-Al film 6a, the SUS film 6b and the Ag-Al film 6c which form the mirror 6 can be made greater. Thus, it is possible to increase durability of the mirror 6.

Further, according to the method of manufacturing the solar cell of the present embodiment, the laminate forming process is performed in a substantially vacuum condition. Thus, the problem that voids or the like are generated in any interfaces between the front plate 2, the cell string 3, the sealants 4, the backing substrate 5 and the mirror 6 and any interfaces between the respective films which forms the mirror 6 can be avoided. Therefore, it is possible to increase the quality of the manufactured solar cell.

The present invention is disclosed with reference to the preferred embodiments. However, it should be understood that the present invention is not limited to the above-described embodiments, and variations and modifications may be made without departing from the scope of the present invention.

For example, in the above-described embodiment, the transparent adhesive film 7 is used for bonding between the mirror 6 and the backing substrate 5; however, it is possible to implement the bonding due to an interfacial effect without using adhesives. Whether the adhesives should be used between the respective elements may be determined based on the required bonding strength and a limitation on a dimension of the thickness of the solar cell 1.

Further, with respect to the configuration of the mirror 6 on the side opposed to the front plate 2, various shapes other than the bellows-like wave surface shape, such as a half pipe shape, a concave shape, etc., may be adopted as long as the mirror 6 can concentrate and reflect the sunlight at an appropriate magnification onto the cells 3a. It is noted that the solar cell 1 shown in the above-described embodiment is a low-concentration ratio type.

Further, in the above-described embodiment, the Ag-Al film, the SUS film and the Ag-Al film which form the mirror 6 after laminate forming are disclosed as basic materials; however, the present invention is not limited to these materials. Any materials which can form the mirror 6 by the laminate forming process may be used.

Further, numeric values described in the foregoing with respect to the temperature condition and the atmospheric condition are exemplary only, and thus these values are not limiting and may be varied as appropriate.

The present application is based on Japanese Priority Application No. 2008-302463, filed on November 27, 2008, the entire contents of which are hereby incorporated by reference.

## Claims

1. A method of manufacturing a solar cell which includes a reflective part configured to reflect sunlight to a back surface of a photovoltaic power generating part, said reflective part including a reflective plate and a backing substrate, said method comprising:
a laminate forming process in which the reflective plate and the backing substrate are formed concurrently by laminate forming.

2. The method claimed in claim 1, wherein the reflective part is, and
the laminate forming process includes forming the reflective part by internally coupling a multilayered piece of an Ag-Al film, a SUS film and an Ag-Al film.

3. The method claimed in claim 1, wherein the laminate forming process is performed substantially in a vacuum.

4. The method claimed in claim 1, wherein the laminate forming process includes coupling the reflective plate and the backing substrate to a front plate and a cell string which is the photovoltaic power generating part.

5. The method claimed in claim 2, wherein the laminate forming process includes stacking a front plate, a sealant, a cell string which is the photovoltaic power generating part, a sealant, the backing substrate and the multilayered piece, and applying a pressure from a back side of the backing substrate with a laminator jig to couple them therebetween.

6. The method claimed in claim 5, wherein in the laminate forming process the multilayered piece is stacked on the backing substrate via a transparent adhesive film.

7. A solar cell comprising:
a photovoltaic power generating part; and
a reflective part provided on a back side of the photovoltaic power generating part for reflecting a sunlight; wherein
the reflective part includes a backing substrate and a reflective plate which is coupled to the backing substrate by laminate forming.
